# EUROPEAN PATENT APPLICATION

(11) **EP 4 637 123 A1**
(43) Date of publication of application: **22.10.2025**
(21) Application number: 24747400.0
(22) Date of filing: 15.01.2024
(51) Int. Cl.: H04M 1/02, H05K 1/14, H01Q 1/24, H05K 1/02

(54) **ELECTRONIC DEVICE COMPRISING FLEXIBLE PRINTED CIRCUIT BOARD**

(30) Priority: 26.01.2023 KR 20230010390; 15.05.2023 KR 20230062477
(71) Applicant: Samsung Electronics Co., Ltd., Suwon-si, Gyeonggi-do 16677 (KR)
(72) Inventor: CHO, Sungjoo, Suwon-si, Gyeonggi-do 16677 (KR); LEE, Yongseok, Suwon-si, Gyeonggi-do 16677 (KR)
(74) Representative: Appleyard Lees IP LLP
(86) International application number: PCT/KR2024/000690
(87) International publication number: WO 2024/158162

(57) **Abstract**

An electronic device according to one embodiment of the present disclosure comprises: a housing: a printed circuit board disposed in the housing; a camera module disposed in one direction of the printed circuit board; a battery disposed in the direction perpendicular to the one direction with respect to the printed circuit board and the camera module; and a flexible printed circuit board for electrically connecting the battery and the printed circuit board, wherein the flexible printed circuit board can include a reinforcement member disposed in an area in which the flexible printed circuit board and other components overlap.

## Description

### [Technical Field]

The present disclosure relates to an electronic device including a flexible printed circuit board.

### [Background Art]

A portable electronic device may include a camera, a battery, and a printed circuit board. The camera and the battery may be disposed at a predetermined distance from each other. A portion of the printed circuit board may be disposed between the camera and the battery. A connector configured to connect electrical components may be disposed on the portion of the printed circuit board that is disposed between the camera and the battery.

### [Disclosure of Invention]

### [Technical Problem]

When a portion of the printed circuit board is disposed between the camera and the battery, it may be difficult for the battery to extend in the direction in which the camera is disposed.

When the area of the printed circuit board positioned between the camera and the battery is removed in order to extend the battery in the direction in which the camera is disposed, a connector configured to connect electrical components may be disposed in another area of the printed circuit board (e.g., an area not positioned between the camera and the battery).

When the disposed position of the connector is changed for battery extension, the flexible printed circuit board may overlap another electronic component and may be damaged. For example, a portion of the flexible printed circuit board connected to the connector may overlap a camera decoration and may be damaged by an external impact.

Accordingly, a structure capable of extending the battery in the direction of the camera while preventing or reducing damage to the flexible printed circuit board connected to the connector may be required.

### [Solution to Problem]

According to an embodiment of the disclosure, an electronic device may include a housing, a printed circuit board, a camera module, a battery, and a flexible printed circuit board.

In an embodiment, the printed circuit board may be disposed in the housing.

In an embodiment, the camera module may be disposed in one direction with respect to the printed circuit board and may include at least one camera.

In an embodiment, the battery may be disposed in a direction perpendicular to the one direction with respect to the printed circuit board and the camera module.

In an embodiment, the flexible printed circuit board may electrically connect the battery and the printed circuit board.

In an embodiment, the flexible printed circuit board may include a reinforcement member disposed in an area where the flexible printed circuit board extends and overlaps another component inside the electronic device.

According to an embodiment of the disclosure, an electronic device may include a housing, a printed circuit board, a camera module, a battery, and a flexible printed circuit board extending between the battery and the camera module to have a surface perpendicular to one surface of the printed circuit board.

### [Advantageous Effects of invention]

According to an embodiment of the disclosure, an electronic device including a flexible printed circuit board may allow the battery to be disposed to extend in the direction in which the camera is positioned.

According to an embodiment of the disclosure, the electronic device may include a reinforcement member to prevent or reduce damage to the flexible printed circuit board caused by overlapping between the flexible printed circuit board and another electronic component inside the electronic device.

According to an embodiment of the disclosure, the electronic device may allow the battery to be disposed to extend in the direction in which the camera is positioned by including a flexible printed circuit board extending between the battery and the camera and having a surface perpendicular to one surface of the printed circuit board.

### [Brief Description of Drawings]

FIG. 1 is a block diagram of an electronic device according to an embodiment in a network environment.
FIGS. 2A and 2B are perspective views of an electronic device according to an embodiment of the disclosure.
FIGS. 3A and 3B are views illustrating an electronic device according to an embodiment of the disclosure.
FIG. 4 is a view illustrating a camera module, a printed circuit board, a first flexible printed circuit board, and a second flexible printed circuit board according to an embodiment of the disclosure.
FIG. 5 is a view illustrating an electronic device including a camera decoration and a support member according to an embodiment of the disclosure.
FIGS. 6A, 6B, and 6C are cross-sectional views illustrating the first flexible printed circuit board and the second flexible printed circuit board according to an embodiment of the disclosure.
FIG. 7 is a view illustrating the first flexible printed circuit board including a reinforcement member according to an embodiment of the disclosure.
FIG. 8 is a view illustrating a third flexible printed circuit board according to an embodiment of the disclosure.
FIG. 9 is a view illustrating the housing and the third flexible printed circuit board according to an embodiment of the disclosure.
FIG. 10 is a view illustrating the third flexible printed circuit board disposed in the housing according to an embodiment of the disclosure.

### [Mode for the Invention]

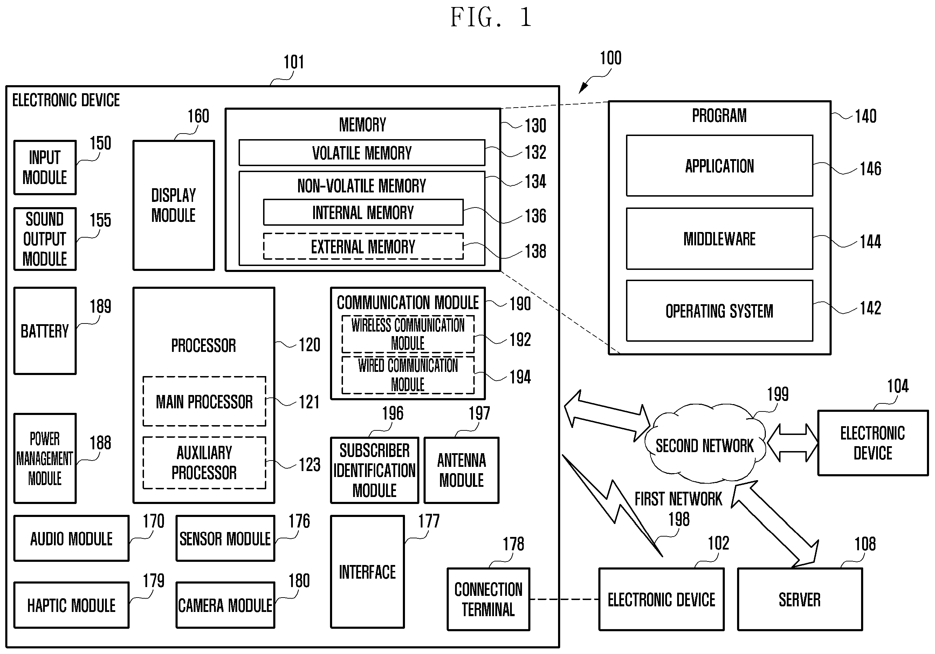

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

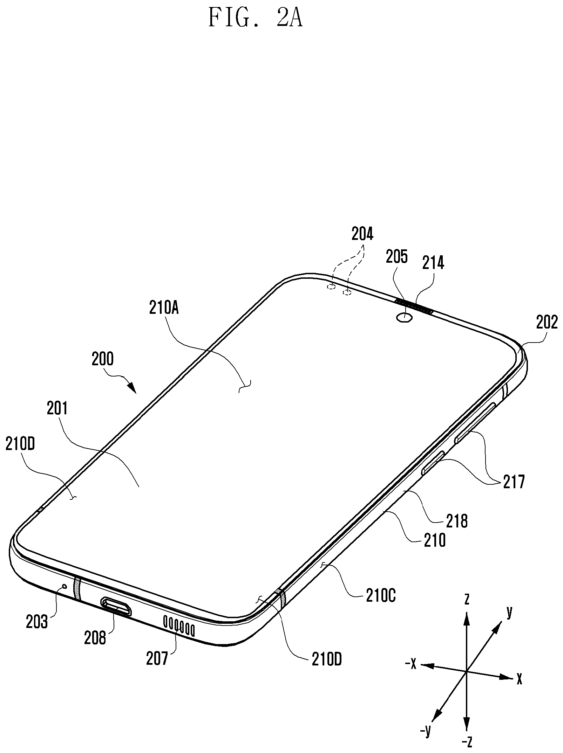

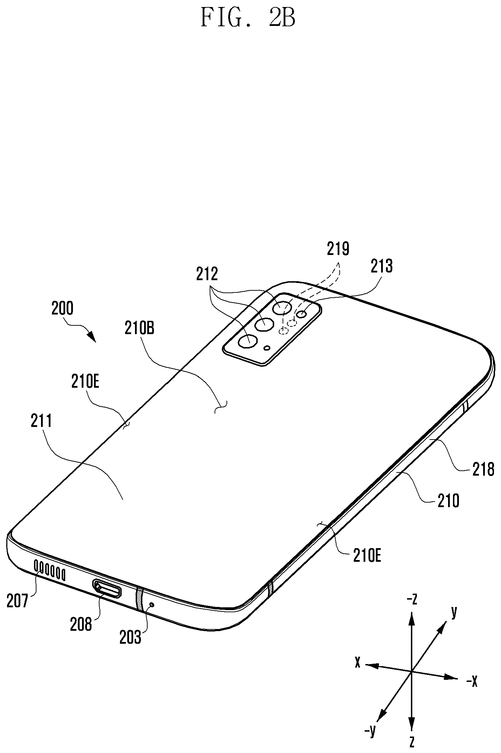

FIG. 2A is a front perspective view of an electronic device 200 according to an embodiment of the disclosure. FIG. 2B is a rear perspective view of the electronic device 200 of FIG. 2A according to an embodiment of the disclosure.

The electronic device 200 of FIGS. 2A and 2B may be at least partially similar to the electronic device 101 of FIG. 1, or may include at least some of the components of the electronic device 101 of FIG. 1.

Referring to FIGS. 2A and 2B, the electronic device 200 according to an embodiment may include a housing 210 having a first surface (or a front surface) 210A, a second surface (or a rear surface) 210B, and a side surface 210C surrounding the space between the first surface 210A and the second surface 210B. In an embodiment (not illustrated), the term "housing 210" may refer to a structure forming a part of the first surface 210A, the second surface 210B, and the side surface 210C. According to an embodiment, at least a portion of the first surface 210A may be defined by a substantially transparent front surface plate 202 (e.g., a glass plate or a polymer plate with various coating layers). The second surface 210B may be provided by a substantially opaque rear surface plate 211. The rear surface plate 211 may be made of, for example, coated or colored glass, ceramic, polymer, metal (e.g., aluminum, stainless steel (STS), or magnesium), or a combination of two or more of these materials. The side surface 210C may be defined by a side surface bezel structure (or a "side surface member") 218 coupled to the front surface plate 202 and the rear surface plate 211 and including metal and/or polymer. In some embodiments, the rear surface plate 211 and the side surface bezel structure 218 may be integrally configured and may include the same material (e.g., a metal material such as aluminum).

In the illustrated embodiment, the front surface plate 202 may include, at the opposite long edges thereof, first areas 210D, which are bent from the first surface 210A toward the rear surface plate 211 and extend seamlessly. In the illustrated embodiment (see FIG. 2B), the rear surface plate 211 may include, at the opposite ends of long edges thereof, second areas 210E, which are bent from the second surface 210B toward the front surface plate 202 and extend seamlessly. In some embodiments, the front surface plate 202 or the rear surface plate 211 may include only one of the first areas 210D or the second areas 210E. In some embodiments, the front surface plate 202 may not include the first areas and the second areas, and may include only a flat surface arranged in parallel to the second surface 210B. In the above-described embodiments, when viewed from a side of the electronic device 200, the side surface bezel structure 218 may have a first thickness (or width) on the side surfaces where the first areas 210D or the second areas 210E are not included, and may have a second thickness smaller than the first thickness, on the side surfaces where the first areas 210D or the second areas 210E are included.

According to an embodiment, the electronic device 200 may include at least one of a display 201, an input device 203, sound output devices 207 and 214, sensor modules 204 and 219, camera modules 205, 212, and 213, key input devices 217, an indicator (not illustrated), or a connector 208. In some embodiments, the electronic device 200 may omit at least one of the components (e.g., the key input devices 217 or the indicator), or may additionally include other components.

The display 201 may be exposed through a substantial portion of, for example, the front surface plate 202. In some embodiments, at least a portion of the display 201 may be exposed through the front surface plate 202 defining the first surface 210A and the first areas 210D of the side surface 210C. The display 201 may be coupled to or disposed adjacent to a touch detection circuit, a pressure sensor configured to measure a touch intensity (pressure), and/or a digitizer configured to detect a magnetic field-type stylus pen. In some embodiments, at least some of the sensor modules 204 and 219 and/or at least some of the key input devices 217 may be disposed in the first areas 210D and/or the second areas 210E.

The input device 203 may include a microphone. In some embodiments, the input device 203 may include a plurality of microphones arranged to detect the direction of sound. The sound output devices 207 and 214 may include speakers. The speakers may include an external speaker 207 and a call receiver 214. In some embodiments, the microphone, the speakers, and the connector 208 may be arranged in the space of the electronic device 200 and may be exposed to the external environment through at least one hole formed in the housing 210. In some embodiments, a hole formed in the housing 210 may be used jointly for the microphone and speakers. In some embodiments, the sound output devices 207 and 214 may include a speaker that operates without a hole in the housing 210 (e.g., a piezo speaker).

The sensor modules 204 and 219 may generate electrical signals or data values corresponding to an internal operating state or an external environmental state of the electronic device 200. The sensor modules 204 and 219 may include, for example, a first sensor module 204 (e.g., a proximity sensor) and/or a second sensor module (not illustrated) (e.g., a fingerprint sensor) disposed on the first surface 210A of the housing 210, and/or a third sensor module 219 (e.g., an HRM sensor) disposed on the second surface 210B of the housing 210. The fingerprint sensor may be placed on the first surface 210A of the housing 210. The fingerprint sensor (e.g., an ultrasonic fingerprint sensor or an optical fingerprint sensor) may be disposed under the display 201 of the first surface 210A. The electronic device 200 may further include at least one of sensor modules (not illustrated), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor 204.

The camera modules 205, 212, and 213 may include a first camera device 205 disposed on the first surface 210A of the electronic device 200, and a second camera device 212 and/or a flash 213 disposed on the second surface 210B. The camera modules 205 and 212 may include one or more lenses, an image sensor, and/or an image signal processor. The flash 213 may include, for example, a light-emitting diode or a xenon lamp. In some embodiments, two or more lenses (e.g., a wide-angle lens and a telephoto lens) and image sensors may be disposed on one surface of the electronic device 200.

The key input devices 217 may be disposed on the side surface 210C of the housing 210. In an embodiment, the electronic device 200 may not include some or all of the above-mentioned key input devices 217, and key input devices 217, which are not included, may be implemented in another form, such as soft keys, on the display 201. In an embodiment, the key input devices 217 may be implemented using pressure sensors included in the display 201.

The indicator may be disposed, for example, on the first surface 210A of the housing 210. The indicator may provide, for example, the state information of the electronic device 200 in an optical form. In an embodiment, the light-emitting element may provide, for example, a light source that operates in conjunction with the operation of the camera module 205. The indicator may include, for example, an LED, an IR LED, and a xenon lamp.

The connector holes 208 may include a first connector hole 208 capable of accommodating a connector (e.g., a USB connector or an interface connector port (IF) module) configured to transmit/receive power and/or data to/from an external electronic device, and/or a second connector hole (or an earphone jack) capable of accommodating a connector configured to transmit/receive an audio signal to/from an external electronic device.

Some camera modules 205 among the camera modules 205 and 212, some sensor modules 204 among the sensor modules 204 and 219, or the indicator may be disposed to be exposed through the display 201. For example, the camera modules 205, the sensor modules 204, or the indicator may be disposed in the inner space of the electronic device 200 to be in contact with the external environment through an opening perforated in the display 201 up to the front surface plate 202 or a transmission area. According to an embodiment, the area where the display 201 and the camera modules 205 face each other may be configured as a transmission area with a predetermined transmittance as a portion of a content display area. According to an embodiment, the transmission area may have a transmittance ranging from about 5% to about 20%. The transmission area may include an area overlapping with an effective area (e.g., a field of view area) of the camera module 205 through which light passes to form an image on the image sensor. For example, the transmission area of the display 201 may include an area having a lower pixel density than the periphery. For example, the transmission area may replace the opening. For example, the camera module 205 may include an under-display camera (UDC). As an embodiment, some sensor modules 204 may be placed in the inner space of the electronic device to perform the functions thereof without being visually exposed through the front surface plate 202. For example, in this case, the area of the display 201 facing the sensor module may not require a perforated opening.

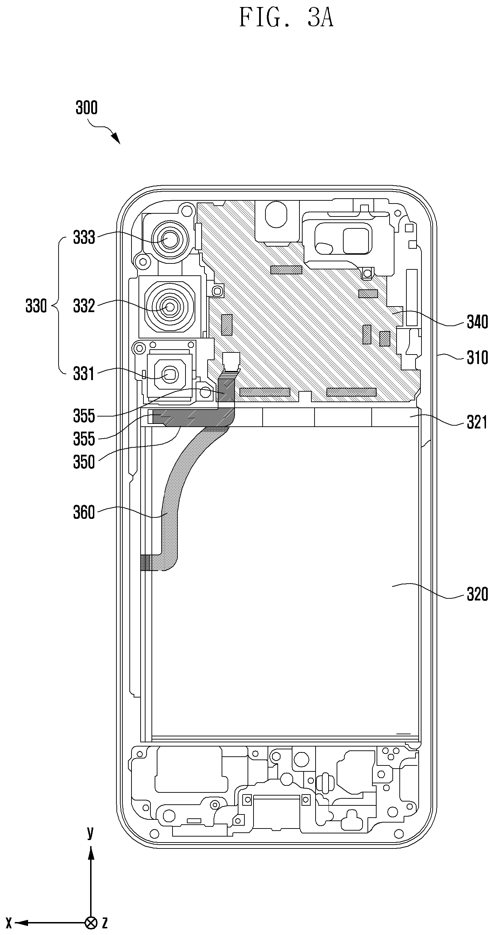

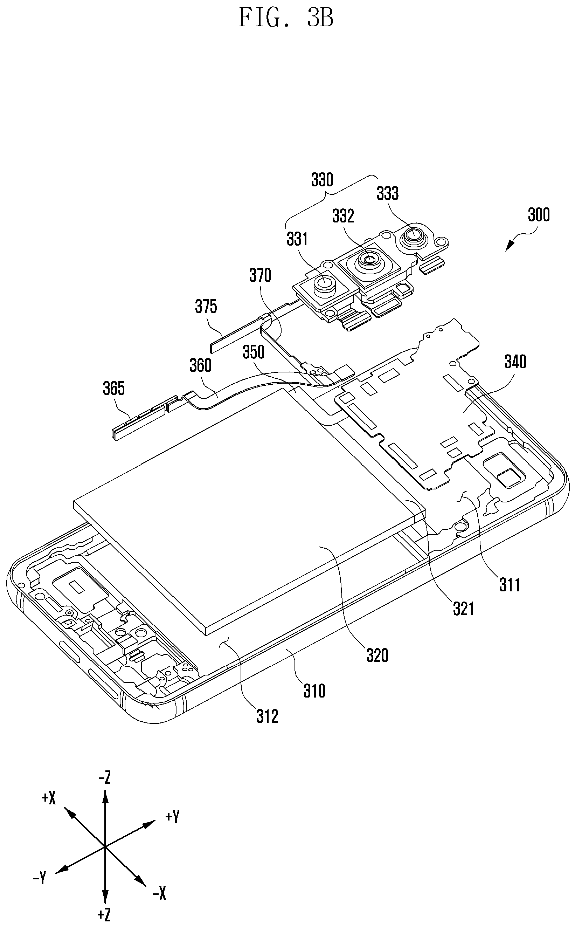

FIGS. 3A and 3B are views illustrating an electronic device 300 according to an embodiment of the disclosure.

FIG. 3A is a view illustrating the electronic device 300 according to an embodiment. FIG. 3A may be a view illustrating the electronic device 300 in a state in which a rear surface cover 390 is not disposed. FIG. 3B is an exploded perspective view of the electronic device 300 according to an embodiment of the disclosure.

The electronic device 300 according to an embodiment illustrated in FIGS. 3A and 3B may represent the electronic device 101 of FIG. 1 or may include at least a part of the electronic device 101 of FIG. 1.

The electronic device 300 according to an embodiment illustrated in FIGS. 3A and 3B may represent the electronic device 200 of FIGS. 2A and 2B or may include at least a part of the electronic device 200 of FIGS. 2A and 2B.

**In** describing the electronic device 300 according to an embodiment of the disclosure, a width direction may refer to the x-axis direction, and a length direction of the electronic device 300 may refer to the y-axis direction. The height direction of the electronic device 300 may refer to the z-axis direction.

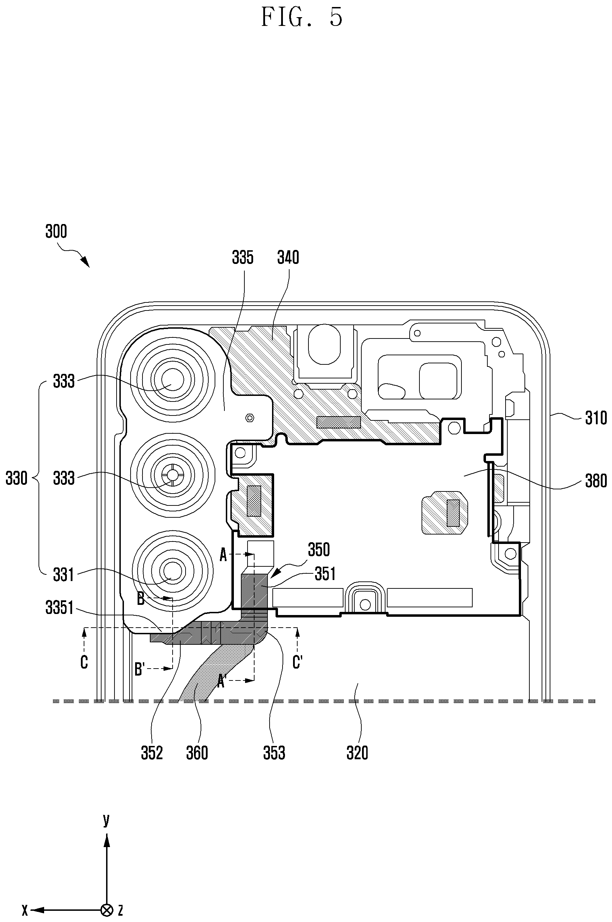

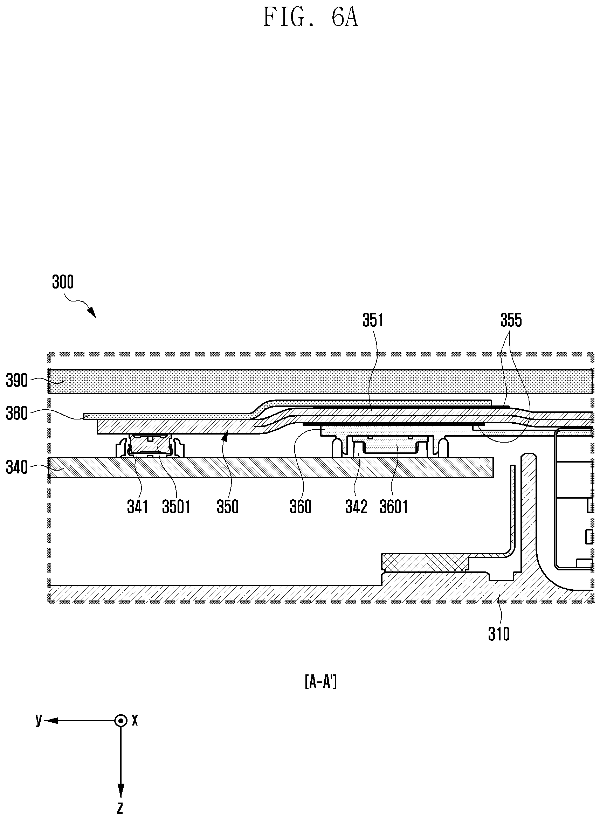

The electronic device 300 according to an embodiment of the disclosure may include a housing 310, a battery 320, a camera module 330, a printed circuit board 340, flexible printed circuit boards 350, 360, and 370, an antenna 365, a support member 380 (see FIG. 5), and/or a rear surface cover 390 (see FIG. 6A).

In an embodiment, the housing 310 may form the exterior of the electronic device 300. Referring to FIG. 3B, the housing 310 may include a first space 311 and/or a second space 312 in which different components of the electronic device 300 may be disposed.

In an embodiment, the printed circuit board 340 may be disposed in the housing 310. For example, the printed circuit board 340 may be disposed in the first space 311 of the housing 310.

In an embodiment, electronic components (e.g., a processor 120 and memory 130 (see FIG. 1)) may be disposed on the printed circuit board 340. The printed circuit board 340 may include connectors 341 and 342 that may be electrically connected to different components of the electronic device 300.

In an embodiment, the camera module 330 may be disposed on one side of the printed circuit board 340. For example, the camera module 330 may be positioned in the positive x-axis direction with respect to the printed circuit board 340.

In an embodiment, the camera module 330 may include a first camera 331, a second camera 332, and/or a third camera 333. The first camera 331, the second camera 332, and the third camera 333 may be disposed along the length direction (e.g., the y-axis direction) of the electronic device 300.

In an embodiment, the battery 320 may be disposed in the housing 310. For example, referring to FIG. 3B, the battery 320 may be disposed in the second space 312 of the housing 310. The battery 320 according to an embodiment may supply power to at least one component of the electronic device 300.

In an embodiment, the battery 320 may include a battery protection module 321. The battery protection module 321 may be disposed to extend along a width direction of the electronic device 300 (e.g., the x-axis direction) at an end of the battery 320 (e.g., the end of the battery 320 facing the printed circuit board 340). The battery protection module 321 may be a protection circuit module (PCM) configured to prevent overcharging and/or over-discharging of the battery 320. For example, the battery protection module 321 may include a battery protection circuit including a protection one chip (POC).

In an embodiment, the first flexible printed circuit board 350 may be connected to the printed circuit board 340 at one end and to the battery 320 at the other end. For example, the first flexible printed circuit board 350 may be connected to the battery protection module 321 of the battery 320 at the other end. The first flexible printed circuit board 350 may electrically connect the printed circuit board 340 and the battery 320.

In an embodiment, the first flexible printed circuit board 350 may extend while being at least partially curved. For example, the first flexible printed circuit board 350 may extend in the width direction of the electronic device 300 (e.g., the x-axis direction) and then may be curved to extend in the length direction of the electronic device 300 (e.g., the y-axis direction).

In an embodiment, the first flexible printed circuit board 350 may include a reinforcement member 355. The reinforcement member 355 may be disposed in a portion of the first flexible printed circuit board 350 that overlaps another component of the electronic device 300.

In an embodiment, the second flexible printed circuit board 360 may be connected to the printed circuit board 340 at one end and to the antenna 365 at the other end. The second flexible printed circuit board 360 may electrically connect the printed circuit board 340 and the antenna 365.

In an embodiment, the third flexible printed circuit board 370 may be connected to the printed circuit board 340 at one end and to the side key 375 at the other end. The third flexible printed circuit board 370 may electrically connect the printed circuit board 340 and the side key 375.

In an embodiment, the third flexible printed circuit board 370 may at least partially extend to have a surface substantially perpendicular to the length direction of the electronic device 300 (e.g., the y-axis direction).

In an embodiment, the third flexible printed circuit board 370 may be electrically connected to the printed circuit board 340.

In an embodiment, a portion of the third flexible printed circuit board 370 may be disposed on a surface of the printed circuit board 340 opposite to a surface on which the first flexible printed circuit board 350 and the second flexible printed circuit board 360 are disposed. For example, terminal ends of the first flexible printed circuit board 350 and the second flexible printed circuit board 360 may be disposed on one surface (e.g., the surface oriented in the -z-axis direction) of the printed circuit board 340, and a terminal end of the third flexible printed circuit board 370 may be disposed on the other surface (e.g., the surface oriented in the +z-axis direction) of the printed circuit board 340.

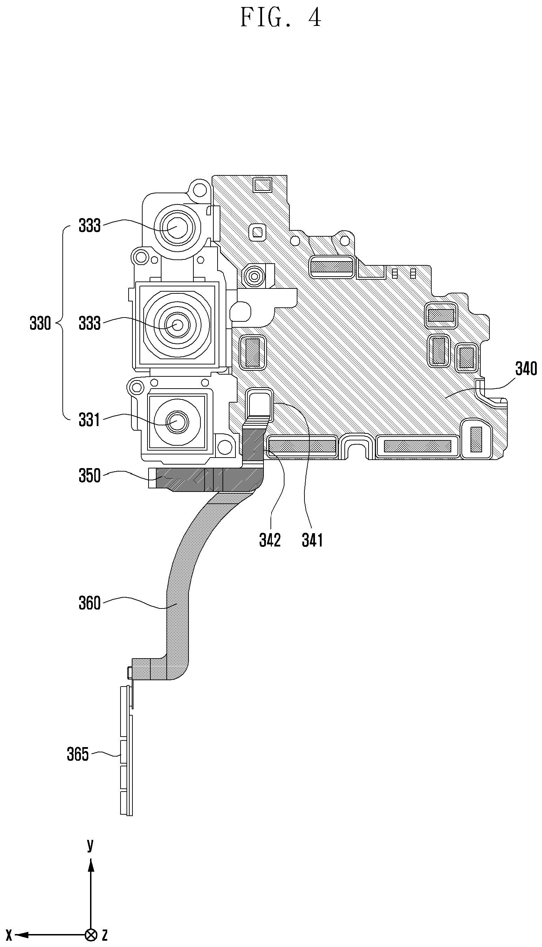

FIG. 4 is a view illustrating a camera module 330, a printed circuit board 340, a first flexible printed circuit board 350, and a second flexible printed circuit board 360 according to an embodiment of the disclosure.

FIG. 4 may be an enlarged view illustrating only some components (e.g., the camera module 330, the printed circuit board 340, the first flexible printed circuit board 350, and the second flexible printed circuit board 360) in the electronic device 300 illustrated in FIGS. 3A and 3B.

Referring to FIG. 4, the camera module 330 may be disposed on one side of the printed circuit board 340. For example, the first camera 331, the second camera 332, and the third camera 333 may be disposed in the +x-axis direction with respect to the printed circuit board 340.

In an embodiment, the first flexible printed circuit board 350 and the second flexible printed circuit board 360 may be connected to the printed circuit board 340. The first flexible printed circuit board 350 may be connected to a first connector 341 of the printed circuit board 340. The second flexible printed circuit board 360 may be connected to a second connector 342 of the printed circuit board 340.

In an embodiment, the first connector 341 and the second connector 342 may be provided on one surface of the printed circuit board 340. The first connector 341 and the second connector 342 may be disposed to be spaced apart in the length direction of the electronic device 300 (e.g., the y-axis direction). The first connector 341 may be disposed at a position where at least a portion of the first connector 341 overlaps the second connector 342 with respect to the width direction of the electronic device 300.

In an embodiment, the first flexible printed circuit board 350 and the second flexible printed circuit board 360 may extend while at least partially overlapping each other. For example, the first flexible printed circuit board 350 and the second flexible printed circuit board 360 may be disposed to overlap each other in a portion extending past the second connector 342.

FIG. 5 is a view illustrating an electronic device 300 including a camera decoration 335 and a support member 380 according to an embodiment of the disclosure.

In an embodiment, the electronic device 300 may include the camera decoration 335 and/or the support member 380.

In an embodiment, the camera decoration 335 may be disposed to cover or surround at least a portion of the camera module 330. For example, the camera decoration 335 may be disposed to at least partially cover or surround the first camera 331, the second camera 332, and the third camera 333.

In an embodiment, the camera decoration 335 may include a decoration extension 3351 protruding toward the battery 320 at one end.

In an embodiment, the first flexible printed circuit board 350 may include a first area 351, a second area 352, and/or a third area 353. The first area 351 may be connected to the printed circuit board 340 and may be an area in which the first flexible printed circuit board 350 extends in the length direction of the electronic device 300 (e.g., the y-axis direction). The second area 352 may be connected to the battery 320 and may be an area in which the first flexible printed circuit board 350 extends in the width direction of the electronic device 300 (e.g., the x-axis direction). The third area 353 may be connected to the first area 351 and the second area 352 and may be an area in which the first flexible printed circuit board 350 is curved.

In an embodiment, the decoration extension 3351 may at least partially overlap the first flexible printed circuit board 350. For example, the decoration extension 3351 may overlap the second area 352 of the first flexible printed circuit board 350.

In an embodiment, the support member 380 may be disposed to cover at least a portion of the printed circuit board 340.

In an embodiment, the support member 380 may be disposed to at least partially cover the first flexible printed circuit board 350 and the second flexible printed circuit board 360. For example, the support member 380 may be disposed to cover terminal ends of the first flexible printed circuit board 350 and the second flexible printed circuit board 360 (e.g., the terminal ends connected to the printed circuit board 340).

In FIG. 5, the support member 380 is illustrated in a transparent form. However, this is merely for exemplary purposes, and the material of the support member 380 may not be limited to a transparent material.

In an embodiment, the support member 380 may serve to fix the positions of the flexible printed circuit boards 350 and 360. The support member 380 may allow the flexible printed circuit boards 350 and 360, which are coupled to the connectors 341 and 342 (see FIG. 6A), to maintain their predetermined positions.

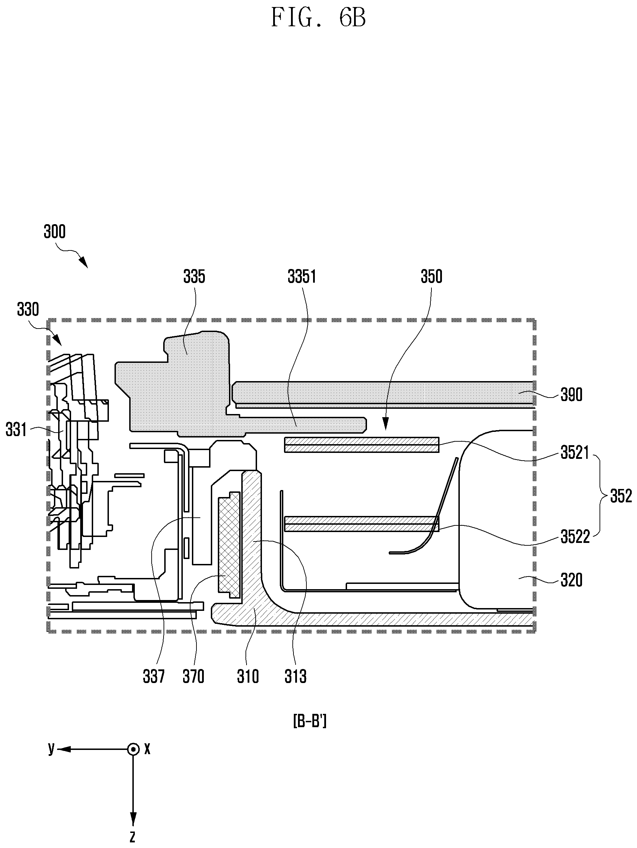

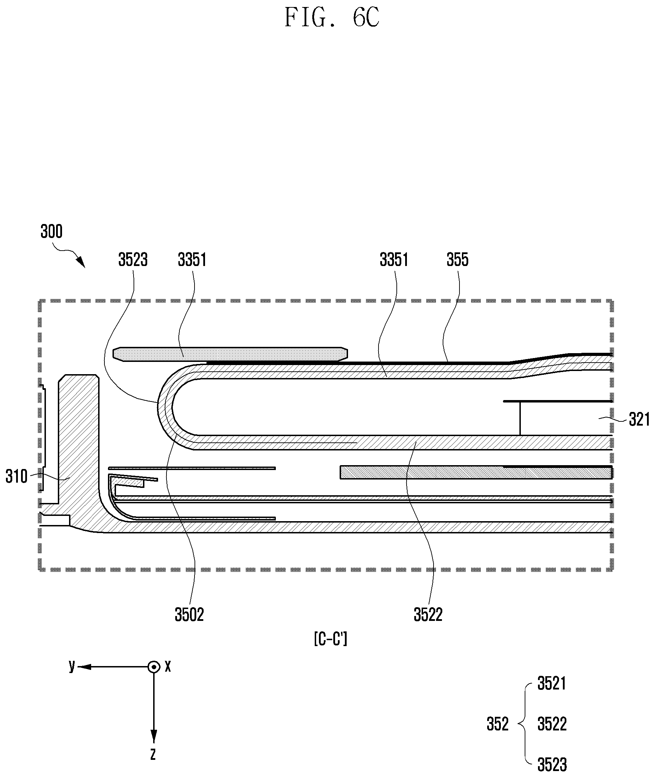

FIGS. 6A, 6B, and 6C are cross-sectional views illustrating the first flexible printed circuit board 350 and the second flexible printed circuit board 360 according to an embodiment of the disclosure.

FIG. 6A may be a cross-sectional view of the electronic device 300 taken along direction A-A' cross-section in FIG. 5. FIG. 6B may be a cross-sectional view of the electronic device 300 taken along direction B-B' in FIG. 5. FIG. 6C may be a cross-sectional view of the electronic device 300 taken along line C-C' in FIG. 5.

Referring to FIG. 6A, the first connector 341 and the second connector 342 may be disposed on one surface of the printed circuit board 340.

In an embodiment, the first connector 341 and the second connector 342 may be positioned to be spaced apart from each other in the length direction of the electronic device 300 (e.g., the y-axis direction).

In an embodiment, the first flexible printed circuit board 350 may be coupled to the first connector 341. The first flexible printed circuit board 350 may include a first connector connection area 3501 at a terminal end. The first flexible printed circuit board 350 may be coupled to the first connector 341 at the first connector connection area 3501.

In an embodiment, the second flexible printed circuit board 360 may be coupled to the second connector 342. The second flexible printed circuit board 360 may include a second connector connection area 3601 at a terminal end. The second flexible printed circuit board 360 may be coupled to the second connector 342 at the second connector connection area 3601.

Referring to FIG. 6A, the first flexible printed circuit board 350 may be disposed in one direction with respect to the second flexible printed circuit board 360. For example, the first flexible printed circuit board 350 may be disposed in a direction opposite to the direction in which the printed circuit board 340 is positioned with respect to the second flexible printed circuit board 360.

Referring to FIG. 6A, the printed circuit board 340, the first flexible printed circuit board 350, and the second flexible printed circuit board 360 may be disposed between the housing 310 and the rear surface cover 390.

Referring to FIG. 6A, in the height direction of the electronic device 300 (e.g., the z-axis direction), the housing 310, the printed circuit board 340, the second flexible printed circuit board 360, the first flexible printed circuit board 350, the support member 380, and the rear surface cover 390 may be disposed in that order.

In an embodiment, the support member 380 may be disposed on one surface of the first flexible printed circuit board 350. For example, the support member 380 may be disposed on the surface of the first flexible printed circuit board 350 oriented in the +z-axis direction.

In an embodiment, the support member 380 may serve to fix the positions of the first flexible printed circuit board 350 and the second flexible printed circuit board 360. The support member 380 according to an embodiment may serve to prevent the first flexible printed circuit board 350 and the second flexible printed circuit board 360 from being displaced from predetermined positions after being fastened to the connectors 341 and 342.

In an embodiment, the first flexible printed circuit board 350, the second flexible printed circuit board 360, the support member 380, and the second connector 342 may overlap in at least a portion of the electronic device 300.

In an embodiment, the first flexible printed circuit board 350 may overlap at least a portion of the support member 380 in the first area 351. For example, referring to FIG. 6A, a portion of the support member 380 may be disposed to cover the first area 351 of the first flexible printed circuit board 350.

In an embodiment, the first flexible printed circuit board 350 may overlap the second flexible printed circuit board 360 in the first area 351. For example, referring to FIG. 6A, the second connector connection area 3601 of the second flexible printed circuit board 360 may overlap the first flexible printed circuit board 350.

In an embodiment, the first flexible printed circuit board 350 may include a reinforcement member 355. The reinforcement member 355 may be disposed on each of one surface and the other surface of the first flexible printed circuit board 350. Referring to FIG. 6A, the reinforcement member 355 may be disposed at positions on one surface and the other surface of the first flexible printed circuit board 350 where the reinforcement member overlaps the second flexible printed circuit board 360 and the second connector 342.

When pressure is applied from the support member 380 toward the second connector 342 in a portion where the first flexible printed circuit board 350 overlaps the support member 380, the second flexible printed circuit board 360, and the second connector 342, the first flexible printed circuit board 350 and the second flexible printed circuit board 360 may be damaged. The reinforcement member 355 according to an embodiment may serve to prevent or reduce damage to the first flexible printed circuit board 350 and the second flexible printed circuit board 360 by reinforcing the strength of the first flexible printed circuit board 350 and the second flexible printed circuit board 360.

In an embodiment, the first connector 341 may have a different height from the second connector 342. For example, a length by which the first connector 341 extends in the z-axis direction may be smaller than a length by which the second connector 342 extends in the z-axis direction.

In an embodiment, since the height of the first connector 341 is smaller than the height of the second connector 342, the first flexible printed circuit board 350 may extend while being at least partially bent. For example, an area of the first flexible printed circuit board 350 disposed on the second connector 342 may be curved and extend toward an area of the first flexible printed circuit board 350 disposed on the first connector 341. The first flexible printed circuit board 350 may be damaged due to a pressure applied to the first flexible printed circuit board 350 in a portion where the first flexible printed circuit board 350 curvedly extends. The reinforcement member 355 according to an embodiment may serve to prevent or reduce damage to the first flexible printed circuit board 350 by reinforcing the strength of the portion in which the first flexible printed circuit board 350 is curved and extends.

The reinforcement member 355 according to an embodiment may include a heat transfer material. The reinforcement member 355 may serve to diffuse heat in the height direction of the electronic device 300 (e.g., the z-axis direction) by including the heat transfer material.

Referring to FIG. 6B, the second area 352 of the first flexible printed circuit board 350 may be disposed between the battery 320 and the first camera 331. For example, with respect to the second area 352 of the first flexible printed circuit board 350, the battery 320 may be positioned in the -y-axis direction and the first camera 331 may be positioned in the +y-axis direction.

In an embodiment, the second area 352 of the first flexible printed circuit board 350 may be at least partially curved and extend. For example, referring to FIGS. 6B and 6C, the second area 352 may include a (2-1)^{th} area 3521 and a (2-2)^{th} area 3522. The (2-1)^{th} area 3521 and the (2-2)^{th} area 3522 may be disposed to be spaced apart from each other in the height direction of the electronic device 300 (e.g., the z-axis direction). The (2-1)^{th} area 3521 and the (2-2)^{th} area 3522 may be connected at a (2-3)^{th} area 3523. The (2-3)^{th} area 3523 may be a portion in which the second area 352 of the first flexible printed circuit board 350 extends while being convexly curved in a width direction of the electronic device 300.

In an embodiment, the first flexible printed circuit board 350 may overlap at least a portion of the camera decoration 335 in the second area 352. For example, referring to FIGS. 6B and 6C, the decoration extension 3351 of the camera decoration 335 may overlap the second area 352 of the first flexible printed circuit board 350.

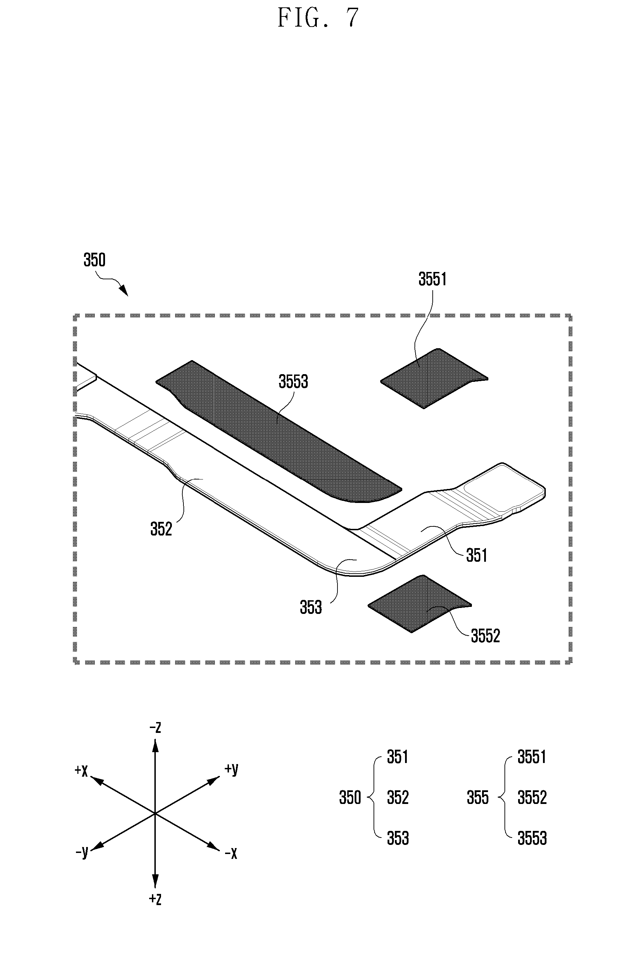

In an embodiment, the reinforcement member 355 may be disposed in the second area 352 of the first flexible printed circuit board 350. For example, referring to FIG. 6C, a third reinforcement member 3553 (see FIG. 7) may be disposed on one surface of the (2-1)^{th} area 3521 (e.g., the surface of the (2-1)^{th} area 3521 facing the decoration extension 3351).

When an external impact is applied to the camera decoration 335, pressure may be applied to the second area 352 of the first flexible printed circuit board 350, which overlaps the decoration extension 3351 of the camera decoration 335, and the first flexible printed circuit board 350 may be damaged. The reinforcement member 355 according to an embodiment may serve to prevent or reduce damage to the first flexible printed circuit board 350 by reinforcing the strength of the second area 352 of the first flexible printed circuit board 350.

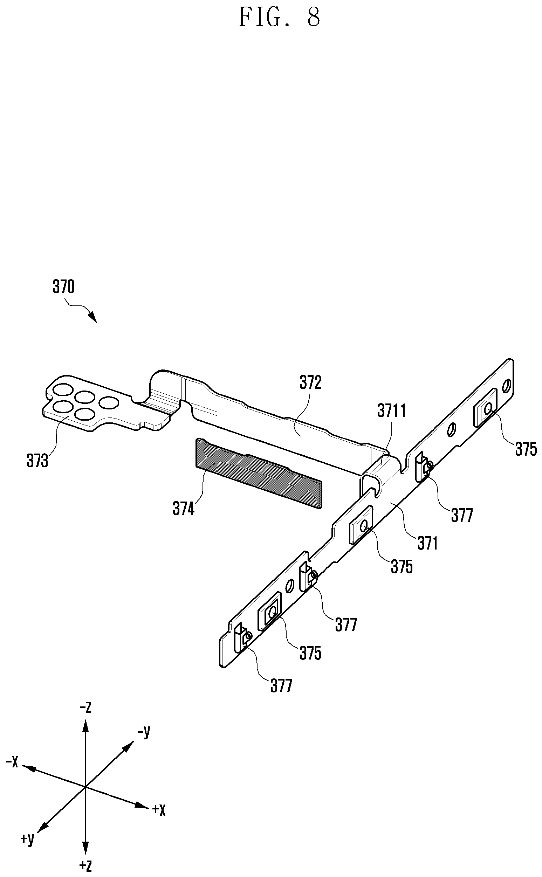

In an embodiment, at least a portion of the third flexible printed circuit board 370 may be disposed between the first camera 331 and the battery 320. For example, referring to FIG. 6B, at least a portion (e.g., the extension area 372 (see FIG. 8)) of the third flexible printed circuit board 370 may be disposed between the first camera 331 and the battery 320.

Referring to FIG. 6B, the camera module 330 may include an assembly portion 337. The assembly portion 337 may be an area of the camera module 330 that is seated in the housing 310. The assembly portion 337 may have a shape that is curved and extend. For example, the assembly portion 337 may extend in the height direction of the electronic device 300 (e.g., the z-axis direction) and then may be at least partially curved and extend in the length direction of the electronic device 300 (e.g., the y-axis direction). A portion of the assembly portion 337 may be seated on the battery partition 313 of the housing 310.

Referring to FIG. 6B, a portion of the third flexible printed circuit board 370 may be disposed in a space surrounded by the battery partition 313 and the assembly portion 337.

A portion of the third flexible printed circuit board 370 may be in contact with the camera module 330. For example, a portion of the third flexible printed circuit board 370 may be positioned in one direction (e.g., the -y-axis direction) with respect to the camera module 330 and may be in contact with the assembly portion 337 of the camera module 330. When the third flexible printed circuit board 370 is in contact with the assembly portion 337, the third flexible printed circuit board 370 may be damaged. Since the third flexible printed circuit board 370 according to an embodiment includes the vertical reinforcement member 374 (see FIG. 8), damage due to contact with the camera module 330 may be prevented or reduced.

Referring to FIG. 6C, the first flexible printed circuit board 350 may at least partially include a slit 3502. For example, the second area 352 of the first flexible printed circuit board 350 may include the slit 3502, and at least a portion thereof (e.g., the (2-3)^{th} area 3523) may be divided into two or more layers. Since the second area 352 of the first flexible printed circuit board 350 is divided into two or more layers, stress caused by bending of the first flexible printed circuit board 350 in the (2-3)^{th} area 3523 may be reduced.

FIG. 7 is a view illustrating the first flexible printed circuit board 350 including the reinforcement member 355 according to an embodiment of the disclosure.

Referring to FIG. 7, the first flexible printed circuit board 350 may include the reinforcement member 355.

In an embodiment, the first flexible printed circuit board 350 may include a first area 351, a second area 352, and/or a third area 353. The first area 351 may be an area in which the first flexible printed circuit board 350 extends in the length direction of the electronic device 300 (e.g., the y-axis direction). The second area 352 may be an area in which the first flexible printed circuit board 350 extends in the width direction of the electronic device 300 (e.g., the x-axis direction).

In an embodiment, the first area 351 and the second area 352 may be connected at the third area 353. The third area 353 may be an area in which the first flexible printed circuit board 350 is curved and extends. The first flexible printed circuit board 350 may extend from the first area 351 and then may be curved at the third area 353 to extend to the second area 352.

In an embodiment, the reinforcement member 355 may include a first reinforcement member 3551, a second reinforcement member 3552, and/or a third reinforcement member 3553.

In an embodiment, the first reinforcement member 3551 may be disposed on one surface of the first area 351. The second reinforcement member 3552 may be disposed on the other surface of the first area 351. A portion of the first flexible printed circuit board 350 on which the first reinforcement member 3551 and the second reinforcement member 3552 are disposed may be a portion overlapping the second connector 342 (see FIG. 6A).

In an embodiment, the third reinforcement member 3553 may be disposed on one surface of the second area 352 of the first flexible printed circuit board 350. The one surface of the second area 352 may be a portion overlapping the decoration extension 3351 (see FIGS. 6B and 6C).

In an embodiment, the reinforcement member 355 may serve to reinforce the strength of the first flexible printed circuit board 350. The reinforcement member 355 may be disposed at a position where the first flexible printed circuit board 350 overlaps another component (e.g., the second connector 342 or the decoration extension 3351) of the electronic device 300 to prevent or reduce damage to the first flexible printed circuit board 350 caused by external pressure.

In an embodiment, the reinforcement member 355 may have a rigid material (e.g., epoxy, polymer) or a flexible material (e.g., silicone).

In an embodiment, the reinforcement member 355 may be manufactured by an ultraviolet (UV) molding method.

In an embodiment, the reinforcement member 355 may be laminated on one surface of the first flexible printed circuit board 350. For example, the first reinforcement member 3551 may be laminated on one surface of the first area 351 of the first flexible printed circuit board 350. The second reinforcement member 3552 may be laminated on the other surface of the first area 351 of the first flexible printed circuit board 350. The third reinforcement member 3553 may be laminated on one surface of the second area 352 of the first flexible printed circuit board 350. For example, the first reinforcement member 3551, the second reinforcement member 3552, and/or the third reinforcement member 3553 may be integrated with the first flexible printed circuit board 350.

In an embodiment, an adhesive member (not illustrated) may be disposed between the reinforcement member 355 and the first flexible printed circuit board 350. For example, the first reinforcement member 3551, the second reinforcement member 3552, and/or the third reinforcement member 3553 may be bonded to the first flexible printed circuit board 350 through the adhesive member (not illustrated).

In an embodiment, the reinforcement member 355 may include a heat transfer material. For example, the reinforcement member 355 may include graphite, a thermal interface material (TIM), carbon fiber, and/or a copper (Cu) sheet.

In an embodiment, the reinforcement member 355 may include a heat transfer material and may diffuse heat of the first flexible printed circuit board 350 to a structure disposed therearound. For example, heat of the first flexible printed circuit board 350 may be diffused through the reinforcement member 355 to the camera decoration 335 and/or the support member 380 that is in contact with the first flexible printed circuit board 350.

FIG. 8 is a view illustrating the third flexible printed circuit board 370 according to an embodiment of the disclosure.

In an embodiment, the third flexible printed circuit board 370 may include a side key area 371, an extension area 372, and/or a contact area 373.

In an embodiment, side keys 375 and side connectors 377 may be disposed on the side key area 371. The side keys 375 may serve to receive input from a user of the electronic device 300. The side connectors 377 may serve to mechanically and/or electrically couple the third flexible printed circuit board 370 to the electronic device 300.

In an embodiment, the side key area 371 may include a plate shape extending in one direction. For example, the side key area 371 may be fabricated in a plate shape having a thickness in the width direction of the electronic device 300 (e.g., the x-axis direction) and may extend in the length direction of the electronic device 300 (e.g., the y-axis direction). One surface of the side key area 371 may be oriented in the width direction of the electronic device 300.

In an embodiment, the extension area 372 may include a plate shape extending in a direction substantially perpendicular to the side key area 371. For example, the extension area 372 may be fabricated in a plate shape having a thickness in the length direction of the electronic device 300 (e.g., the y-axis direction) and may extend in the width direction of the electronic device 300 (e.g., the x-axis direction). One surface of the extension area 372 may be oriented in the length direction of the electronic device 300.

In an embodiment, the extension area 372 may be connected to the side key area 371 at one end and to the contact area 373 at the other end.

In an embodiment, the side key area 371 and the extension area 372 may be connected via a bent area 3711. The bent area 3711 may be an area where the third flexible printed circuit board 370 is convexly curved and extends in the height direction (e.g., the z-axis direction).

In an embodiment, the contact area 373 may include a plate shape extending in a direction substantially perpendicular to the extension area 372. For example, the contact area 373 may be fabricated in a plate shape having a thickness in the height direction of the electronic device 300 (e.g., the z-axis direction) and may be connected to the extension area 372.

In an embodiment, the contact area 373 may be disposed on the printed circuit board 340 (see FIG. 3B). The third flexible printed circuit board 370 may be electrically connected to the printed circuit board 340 (see FIG. 3B) at the contact area 373.

In an embodiment, the third flexible printed circuit board 370 may include a vertical reinforcement member 374. In an embodiment, the vertical reinforcement member 374 may be disposed on one surface of the extension area 372. For example, the vertical reinforcement member 374 may be disposed on the surface of the extension area 372 oriented in the +y-axis direction.

In an embodiment, the vertical reinforcement member 374 may have a rigid material (e.g., epoxy, polymer) or a flexible material (e.g., silicone).

In an embodiment, the vertical reinforcement member 374 may be manufactured by an ultraviolet (UV) molding method.

In an embodiment, the vertical reinforcement member 374 may include a heat transfer material. For example, the vertical reinforcement member 374 may include graphite, a thermal interface material (TIM), and/or a copper (Cu) sheet.

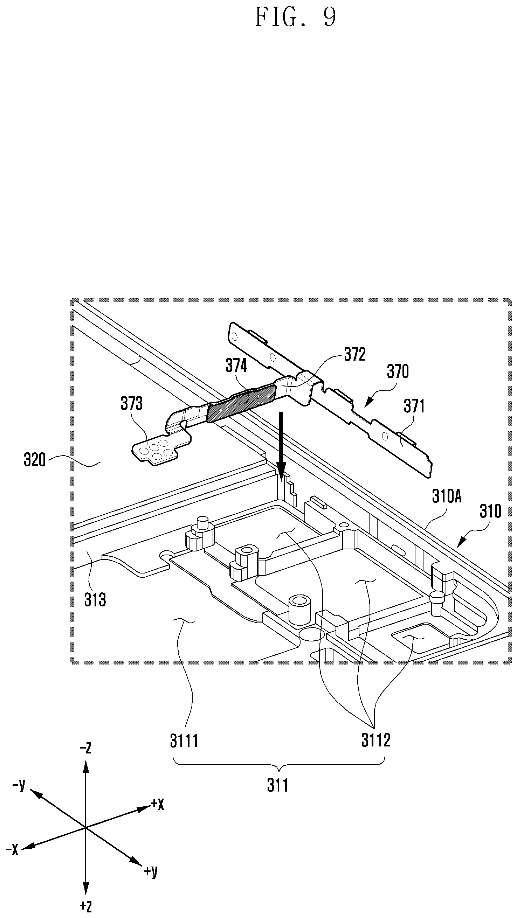

FIG. 9 is a view illustrating the housing 310 and the third flexible printed circuit board 370 according to an embodiment of the disclosure.

In an embodiment, the housing 310 may include a battery partition 313 and/or a first space 311.

In an embodiment, the battery partition 313 may be a partition that separates the battery 320 from other components (e.g., the printed circuit board 340; see FIG. 3A) of the electronic device 300 such that the battery and the components are disposed in separate locations.

In an embodiment, the first space 311 may include a camera placement space 3112 and/or a board placement space 3111. The camera placement space 3112 may be a space in which the camera module 330 (see FIG. 3A) is placed. The board placement space 3111 may be a space in which the printed circuit board 340 (see FIG. 3A) is placed.

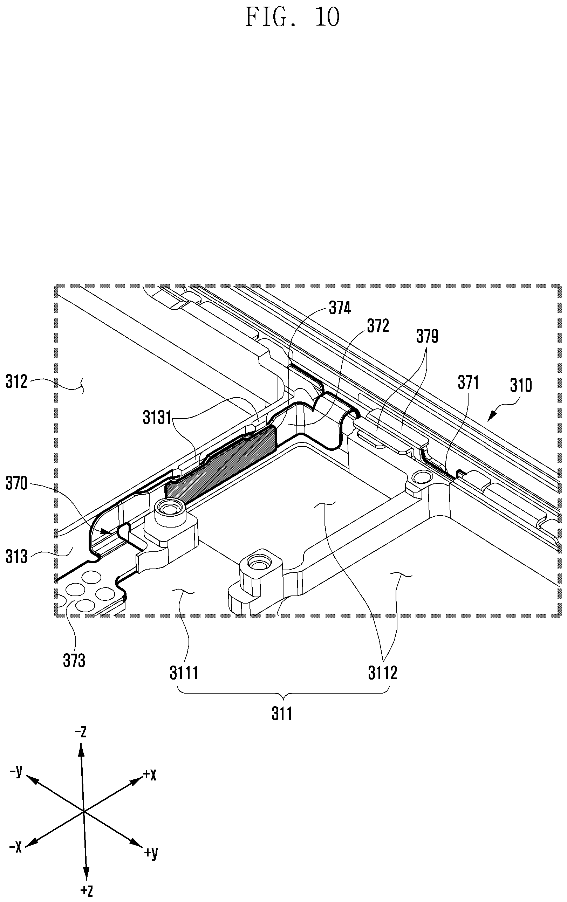

In an embodiment, the battery 320 may be disposed in one direction with respect to the battery partition 313. The camera placement space 3112 and the board placement space 3111 may be disposed in the other direction with respect to the battery partition 313. For example, referring to FIG. 10, the battery 320 may be disposed in the -y-axis direction with respect to the battery partition 313, and the camera placement space 3112 and the board placement space 3111 may be disposed in the +y-axis direction with respect to the battery partition 313.

In an embodiment, the third flexible printed circuit board 370 may be disposed in the housing 310. The third flexible printed circuit board 370 may be disposed such that the extension area 372 comes into contact with the battery partition 313 of the housing 310.

In an embodiment, the extension area 372 of the third flexible printed circuit board 370 may extend to have a surface substantially parallel to the battery partition 313. For example, the extension area 372 may extend to have a surface parallel to the width direction of the electronic device 300 (e.g., the x-axis direction) and the height direction of the electronic device 300 (e.g., the z-axis direction). The extension area 372 of the third flexible printed circuit board 370 may extend to have a surface substantially perpendicular to one surface of the printed circuit board 340 (see FIG. 3B).

Since the extension area 372 of the third flexible printed circuit board 370 does not extend in the length direction of the electronic device 300 (e.g., the y-axis direction), the third flexible printed circuit board 370 may be disposed between the camera module 330 and the battery 320 even when a space between the camera module 330 and the battery 320 is relatively small. Since the extension area 372 of the third flexible printed circuit board 370 does not extend in the length direction of the electronic device 300 (e.g., the y-axis direction), an additional space may be secured inside the electronic device 300 for placing an electronic component (e.g., the battery 320) in the length direction of the electronic device 300.

In an embodiment, the housing 310 may include a side surface 310A. The side surface 310A of the housing 310 may be a surface that forms a periphery of the housing 310. For example, referring to FIG. 9, the side surface 310A of the housing 310 may extend in the y-axis direction to form the periphery of the housing 310.

In an embodiment, the third flexible printed circuit board 370 may be disposed such that the side key area 371 comes into contact with the side surface 310A of the housing 310. For example, the side key area 371 may be disposed to face the interior of the housing 310 from the side surface 310A of the housing 310.

When the electronic device 300 is assembled, the third flexible printed circuit board 370 may be disposed in the housing 310, and then the camera module 330 (see FIG. 3B) may be disposed in the housing 310. When the camera module 330 is assembled to the housing 310, a portion of the camera module 330 may come into contact with the third flexible printed circuit board 370, which has already been disposed, and the third flexible printed circuit board 370 may be damaged. Since the third flexible printed circuit board 370 according to an embodiment includes the vertical reinforcement member 374, damage due to contact with the camera module 330 may be prevented or reduced.

FIG. 10 is a view illustrating the third flexible printed circuit board 370 disposed in the housing 310 according to an embodiment of the disclosure.

Referring to FIG. 10, the third flexible printed circuit board 370 may be disposed in the housing 310. The extension area 372 of the third flexible printed circuit board 370 may be disposed to come into contact with the battery partition 313 of the housing 310.

In an embodiment, the first space 311 may be positioned in one direction (e.g., the +y-axis direction) with respect to the battery partition 313, and the second space 312 may be positioned in the other direction (e.g., the -y-axis direction).

In an embodiment, the contact area 373 of the third flexible printed circuit board 370 may be disposed in the board placement space 3111 of the housing 310.

The electronic device 300 according to an embodiment may include a side surface support member 379. The side surface support member 379 may be disposed to come into contact with the side key area 371 of the third flexible printed circuit board 370. The side surface support member 379 may serve to fix the position of the third flexible printed circuit board 370.

In an embodiment, the battery partition 313 may include a fixing member 3131. The fixing member 3131 may have a hook shape. The battery partition 313 may include a plurality of fixing members 3131.

In an embodiment, the fixing member 3131 may serve to prevent the third flexible printed circuit board 370 from deviating from a predetermined position of the housing 310. For example, the fixing member 3131 may be in contact with the extension area 372 of the third flexible printed circuit board 370 and may prevent the third flexible printed circuit board 370 from being displaced in the height direction of the electronic device 300 (e.g., the z-axis direction).

According to an embodiment of the disclosure, an electronic device 300 may include a housing 310, a printed circuit board 340, a camera module 330, a battery 320, and a flexible printed circuit board 350.

In an embodiment, the printed circuit board 340 may be disposed in the housing 310.

In an embodiment, the camera module 330 may be disposed in one direction (e.g., the x-axis direction) of the printed circuit board 340 and may include at least one camera 331, 332, or 333.

In an embodiment, the battery 320 may be disposed in a direction (e.g., the - y-axis direction) perpendicular to the one direction with respect to the printed circuit board 340 and the camera module 330.

In an embodiment, the flexible printed circuit board 350 may electrically connect the battery 320 and the printed circuit board 340.

In an embodiment, the flexible printed circuit board 350 may include a reinforcement member 355 disposed in an area where the flexible printed circuit board 350 extends and overlaps another component inside the electronic device.

In an embodiment, the electronic device 300 may further include a support member 380 at least partially disposed on the flexible printed circuit board 350, and the reinforcement member 355 may be disposed on one surface of the flexible printed circuit board 350 facing the support member 380.

In an embodiment, the camera module 330 may include a plurality of cameras 331, 332, and 333, and a camera decoration 335 surrounding the plurality of cameras 331, 332, and 333. The camera decoration 335 may at least partially overlap the flexible printed circuit board 350, and the reinforcement member 355 may be disposed on one surface of the flexible printed circuit board 350 that overlaps the camera decoration 335.

In an embodiment, the reinforcement member 355 may include a heat transfer material.

In an embodiment, the flexible printed circuit board 350 may include a first area 351 connected to the printed circuit board 340 and extending in a length direction of the electronic device, a second area 352 connected to the battery 320 and extending in a width direction of the electronic device, and a third area 353 connected to the first area 351 and the second area 352 and extending from the width direction to the length direction of the electronic device while being curved.

In an embodiment, the reinforcement member 355 may be disposed in portions of the first area 351 and the second area 352 where the flexible printed circuit board 350 overlaps another component inside the electronic device 300.

In an embodiment, at least a portion of the second area 352 may extend while being convexly curved in the width direction of the electronic device 300, and the flexible printed circuit board 350 may include a slit 3502 dividing the portion of the second area 352, which extends while being curved, into two layers.

In an embodiment, the flexible printed circuit board 350 may be a first flexible printed circuit board 350, and the electronic device 300 may further include an antenna 365, and a second flexible printed circuit board 360 electrically connecting the antenna 365 and the printed circuit board 340 and at least partially overlapping the first flexible printed circuit board 350.

In an embodiment, the reinforcement member 355 may include a first reinforcement member 3551 disposed on one surface of the first flexible printed circuit board 350, and a second reinforcement member 3552 disposed on the other surface of the first flexible printed circuit board 350 facing the second flexible printed circuit board 360.

In an embodiment, the printed circuit board 340 may include a first connector 341 and a second connector 342 disposed to be spaced apart from the first connector 341 in the length direction of the electronic device 300. The first flexible printed circuit board 350 may be connected to the first connector 341 and may extend to at least partially overlap the second connector 342, and the second flexible printed circuit board 360 may be connected to the second connector 342.

In an embodiment, the electronic device 300 may include a third flexible printed circuit board 370 at least partially extending between the battery 320 and the camera module 330 to have a surface perpendicular to the one surface of the printed circuit board 340. The third flexible printed circuit board 370 may include a vertical reinforcement member 374 disposed in an area where the third flexible printed circuit board 370 extends and overlaps another component inside the electronic device.

In an embodiment, the third flexible printed circuit board 370 may include a side key area 371 in which a side key 375 configured to receive input from a user of the electronic device 300 is disposed, a contact area 373 disposed on the printed circuit board 340, and an extension area 372 connected to the side key area 371 at one end and to the contact area 373 at the other end, and extending between the battery 320 and the camera module 330 to have a surface perpendicular to the one surface of the printed circuit board 340.

In an embodiment, the first flexible printed circuit board 350 and the second flexible printed circuit board 360 may be connected to the one surface of the printed circuit board 340, and the third flexible printed circuit board 370 may be connected to the other surface of the printed circuit board 340.

In an embodiment, the housing 310 may include a battery partition 313 provided between the battery 320 and the third flexible printed circuit board 370, and the battery partition 313 may include a fixing member 3131 configured to fix the position of the third flexible printed circuit board 370.

According to an embodiment of the disclosure, the electronic device 300 may include a housing 310, a printed circuit board 340, a camera module 330, a battery 320, and a flexible printed circuit board 370 extending between the battery 320 and the camera module 330 to have a surface perpendicular to one surface of the printed circuit board 340.

In an embodiment, the flexible printed circuit board 370 may include a side key area 371 in which a side key 375 configured to receive input from a user of the electronic device is disposed, a contact area 373 disposed on the printed circuit board 340, and an extension area 372 connected to the side key area 371 at one end and to the contact area 373 at the other end, and extending between the battery 320 and the camera module 330 to have a surface perpendicular to the one surface of the printed circuit board 340.

In an embodiment, the extension area 372 may extend to have a surface perpendicular to the side key area 371 and the contact area 373.

In an embodiment, the extension area 372 may be disposed on the battery partition 313 and may be prevented from being displaced in the height direction of the electronic device by the fixing member 3131, and the reinforcement member 374 may be disposed on one surface of the extension area 372 facing away from the battery partition 313.

In an embodiment, the reinforcement member 374 may include a heat transfer material.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration.

According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a housing (310);
a printed circuit board (340) disposed in the housing;
a camera module (330) disposed in one direction with respect to the printed circuit board and comprising at least one camera (331, 332, 333);
a battery (320) disposed in a direction perpendicular to the one direction with respect to the printed circuit board and the camera module; and
a flexible printed circuit board (350) electrically connecting the battery and the printed circuit board,
wherein the flexible printed circuit board comprises a reinforcement member (355) disposed in an area in which the flexible printed circuit board overlaps and extends across another component inside the electronic device.

2. The electronic device of claim 1, further comprising:
a support member (380) at least partially disposed on the flexible printed circuit board,
wherein the reinforcement member is disposed on one surface of the flexible printed circuit board facing the support member.

3. The electronic device of claim 1, wherein the camera module further comprises a camera decoration (335) surrounding the at least one camera,
wherein the camera decoration at least partially overlaps the flexible printed circuit board, and
wherein the reinforcement member is disposed on one surface of the flexible printed circuit board overlapping the camera decoration.

4. The electronic device of claim 1, wherein the reinforcement member comprises a heat transfer material.

5. The electronic device of claim 1, wherein the flexible printed circuit board comprises:
a first area (351) connected to the printed circuit board and extending in a length direction of the electronic device;
a second area (352) connected to the battery and extending in a width direction of the electronic device; and
a third area (353) connected to the first area and the second area, and extending from the width direction to the length direction of the electronic device while being bent.

6. The electronic device of claim 5, wherein the reinforcement member is disposed in portions of the first area and the second area where the flexible printed circuit board overlaps another component inside the electronic device.

7. The electronic device of claim 5, wherein at least a portion of the second area extends while being convexly curved in the width direction of the electronic device, and
wherein the flexible printed circuit board comprises a slit (3502) dividing the portion of the second area, which extends while being curved, into two layers.

8. The electronic device of claim 1, wherein the flexible printed circuit board is a first flexible printed circuit board (350), and
wherein the electronic device further comprises:
an antenna (365); and
a second flexible printed circuit board (360) electrically connecting the antenna and the printed circuit board, and at least partially overlapping the first flexible printed circuit board.

9. The electronic device of claim 8, wherein the reinforcement member comprises:
a first reinforcement member (3551) disposed on one surface of the first flexible printed circuit board; and
a second reinforcement member (3552) disposed on another surface of the first flexible printed circuit board facing the second flexible printed circuit board.

10. The electronic device of claim 8, wherein the printed circuit board comprises:
a first connector (341); and
a second connector (342) disposed to be spaced apart from the first connector in the length direction of the electronic device,
wherein the first flexible printed circuit board is connected to the first connector and extends to at least partially overlap the second connector, and
wherein the second flexible printed circuit board is connected to the second connector.

11. The electronic device of claim 8, further comprising:
a third flexible printed circuit board (370) at least partially extending between the battery and the camera module so as to have a surface perpendicular to one surface of the printed circuit board,
wherein the third flexible printed circuit board comprises a vertical reinforcement member (374) disposed in an area where the third flexible printed circuit board extends and overlaps another component inside the electronic device.

12. The electronic device of claim 11, wherein the third flexible printed circuit board comprises:
a side key area (371) where a side key configured to receive input from a user of the electronic device is disposed;
a contact area (373) disposed on the printed circuit board; and
an extension area (372) connected to the side key area at one end and to the contact area at another end, and extending between the battery and the camera module so as to have a surface perpendicular to the one surface of the printed circuit board.

13. The electronic device of claim 11, wherein the first flexible printed circuit board and the second flexible printed circuit board are connected to the one surface of the printed circuit board, and
wherein the third flexible printed circuit board is connected to another surface of the printed circuit board.

14. The electronic device of claim 12, wherein the housing comprises a battery partition (313) provided between the battery and the third flexible printed circuit board, and
wherein the battery partition comprises a fixing member (3131) configured to fix a position of the third flexible printed circuit board.

15. The electronic device of claim 14, wherein the extension area is disposed on the battery partition and is prevented from being displaced in a height direction of the electronic device by the fixing member, and
wherein the vertical reinforcement member is disposed on one surface of the extension area facing away from the battery partition.
